(19) Europäisches Patentamt / European Patent Office / Office européen des brevets

(11) **EP 3 309 570 B1**

(12) **EUROPEAN PATENT SPECIFICATION**

(45) Date of publication and mention of the grant of the patent:
**27.10.2021 Bulletin 2021/43**

(21) Application number: **16807157.9**

(22) Date of filing: **12.02.2016**

(51) Int Cl.:
*G01R 33/02* (2006.01)     *G01R 33/07* (2006.01)
*G01R 35/00* (2006.01)     *G07D 7/04* (2016.01)
*G07D 7/20* (2016.01)     *G01R 33/00* (2006.01)

(86) International application number:
**PCT/JP2016/054099**

(87) International publication number:
**WO 2016/199450 (15.12.2016 Gazette 2016/50)**

(54) **MAGNETIC SENSOR DEVICE**

MAGNETSENSORVORRICHTUNG

DISPOSITIF DE CAPTEUR MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.06.2015 JP 2015116841**

(43) Date of publication of application:
**18.04.2018 Bulletin 2018/16**

(73) Proprietor: **Vienex Corporation
Kanonji-shi, Kagawa 768-0021 (JP)**

(72) Inventors:
• **BAKU, Kenchu
Kanonji-shi
Kagawa 768-0021 (JP)**

• **HIGUCHI, Shinsuke
Kanonji-shi
Kagawa 768-0021 (JP)**

(74) Representative: **Mewburn Ellis LLP
Aurora Building
Counterslip
Bristol BS1 6BX (GB)**

(56) References cited:
**EP-A1- 2 722 983        EP-A1- 2 835 660
WO-A1-2014/077276        WO-A1-2014/168180
JP-A- S5 273 793        JP-A- S5 273 793
JP-A- S5 273 793        JP-A- H08 139 386
JP-A- H08 194 040        JP-A- 2000 088 867
JP-A- 2002 296 332        JP-A- 2005 037 337
JP-A- 2006 126 144        US-A1- 2008 030 191**

**Description**

TECHNICAL FIELD

The present invention relates to a magnetic sensor device for detecting a magnetic body contained in paper sheets such as banknotes or securities.

BACKGROUND ART

Recently, forged banknotes, securities, and the like have become more sophisticated, and therefore it is difficult to discriminate authenticity.
Meanwhile, in order to prevent forgery and determine authenticity, various kinds of advanced security measures are applied to paper sheets. For example, magnetic bodies forming a fine print pattern are arranged on a paper sheet, or a plurality of magnetic bodies having different magnetic characteristics is arranged on a paper sheet.
A conventional magnetic sensor device includes, as main constituents, a magnetic field generation unit which magnetizes a magnetic body contained in a paper sheet, a magnetoelectric conversion element which converts magnetic field intensity of the magnetized magnetic body into a voltage or the like, and a detection unit which detects output of the magnetoelectric conversion element. The detection unit detects a magnetic body contained in a paper sheet. Many conventional magnetic sensor devices only have the ability to recognize the presence or absence of a magnetic body contained in a paper sheet, and cannot sufficiently detect the above-described security measures using a magnetic body contained in a paper sheet. Therefore, in order to detect quantity of magnetism or the amount of the magnetic body contained in a paper sheet, a device in which two magnetoelectric conversion elements are paired for detecting a differential output of the two magnetoelectric conversion elements has been developed. However, as described later, the problem of using a pair of magnetoelectric conversion elements is not solved.
In the above-described magnetic field generation unit, a permanent magnet or an electromagnetic coil generates a magnetic field (referred to as a bias magnetic field) on a transport path of a paper sheet. As the magnetoelectric conversion element, a magnetoresistive element, a magnetic head, a Hall element, or the like is used. The magnetoelectric conversion element is placed in the bias magnetic field. When a paper sheet passes near the magnetoelectric conversion element, the bias magnetic field changes due to a magnetic body contained in the paper sheet. Therefore, output of the magnetoelectric conversion element changes. The magnetic body is detected by detecting this output signal.
Incidentally, the bias magnetic field itself is far greater than a change in the bias magnetic field caused by the magnetic body contained in the paper sheet. Therefore, the above detection unit is saturated with output of the magnetoelectric conversion element, and cannot detect a change in the bias magnetic field. Therefore, in order to detect a change in the bias magnetic field, it is necessary to extract output of the magnetoelectric conversion element, the output being obtained by excluding the portion corresponding to the original bias magnetic field.
As a method for this purpose, in a conventional magnetic sensor device, basically, two magnetoelectric conversion elements are paired and arranged in a common bias magnetic field, the magnetoelectric conversion elements are electrically connected in series, and a differential voltage or a differential current is used as an output signal.
For example, in Patent Document 1, a magnetoresistive element and a permanent magnet giving a bias magnetic field to this magnetoresistive element form a set. Two magnetoresistive elements used in the sets of the magnetoresistive element and the permanent magnet are electrically connected in series. The differential voltage of the sets is output.
Patent Document 2 relates to a magnetic sensor device including a magnetic detection unit in which magnetoresistive elements are connected in series between a voltage input terminal and a ground terminal, and a voltage divided by the plurality of magnetoresistive elements is output as an output signal from a voltage output terminal connected to a connection portion of the plurality of magnetoresistive elements connected in series. In the plurality of magnetoresistive elements constituting the magnetic detection unit in this magnetic sensor device, magnetosensitive units are arranged such that at least one magnetosensitive unit constituting one magnetoresistive element is not arranged on both sides with respect to the plurality of other magnetosensitive units constituting the one magnetoresistive element.
Patent Document 3 discloses that two Hall elements are disposed at both ends of a permanent magnet so as to receive a common bias magnetic field. Output of the Hall element over which a paper sheet passes changes because the bias magnetic field is changed due to a magnetic body contained in the paper sheet. In contrast, output of the other Hall element does not change because the other Hall element is not affected by passage of the paper sheet. Therefore, the differential output of these Hall elements is a signal proportional to the portion of the bias magnetic field changed due to the magnetic body contained in the paper sheet, in other words, proportional to magnetic flux density of the magnetic body (referred to as the amount of the magnetic body in this document) contained in the paper sheet.
WO 2014/077276 proposes a signal processing device suitable for reading pattern information, such as an image printed with magnetic ink on paper currency or other notes, by using a line sensor in which a plurality of sensing elements are disposed in a line. EP 2 722 983 proposes an amplifier and signal processing device usable to detect magnetic patterns in a detectable body. US 2008/0030191 proposes a magnetic sensor circuit configured to reduce the influence of device offset voltages. JP52-073793 proposes a magnetic detection circuit for bank notes. EP 2 835 660 proposes a magnetic sensing device and bill validator. WO 2014/168180 proposes a magnetic property determination device.

PRIOR ART DOCUMENT

PATENT DOCUMENT

>   Patent Document 1: JP 2000-346605 A
>   Patent Document 2: JP 2005-37337 A
>   Patent Document 3: JP 2003-149313 A

SUMMARY OF THE INVENTION

PROBLEMS TO BE SOLVED BY THE INVENTION

However, in the above conventional methods, since a plurality of magnetoelectric conversion elements is used at a plurality of locations, it is difficult for the magnetoelectric conversion elements to receive a common bias magnetic field due to individual differences of characteristics of the magnetoelectric conversion elements and the magnetic field generation unit, or individual differences with respect to an influence of a change in environment such as temperature. Therefore, fluctuation of differential output of the plurality of magnetoelectric conversion elements cannot be avoided.

The present invention has been made in order to solve the above-mentioned problem in the conventional magnetic sensor devices. An object of the present invention to provide a magnetic sensor device which is less affected by individual differences of respective members such as a magnetic field generation unit and a magnetoelectric conversion element, and a change in environment, and enables stable output of the magnetoelectric conversion element. The magnetic sensor device can stably detect not only the presence or absence of a magnetic body included in a paper sheet but also quantity of magnetism or the amount of a plurality of magnetic bodies having different magnetic characteristics, used as an advanced measure for preventing forgery and determining authenticity.

MEANS FOR SOLVING THE PROBLEMS

A magnetic sensor device for detecting a magnetic body contained in a paper sheet transported on a transport path, according to the present invention is provided by claim 1.

In the device according to the present invention, the correction unit is provided to detect a change caused by the magnetic body contained in a paper sheet by means of offsetting. Therefore, it is possible to detect the change by subtracting from the output of the magnetoelectric conversion element the portion corresponding to the bias magnetic field. Furthermore, an element whose output linearly changes with respect to magnetic field intensity is used as the magnetoelectric conversion element. Therefore, it is possible to avoid an influence caused by individual differences of the respective component members such as the magnetic field generation unit and to highly accurately detect a change in magnetic flux density caused by the magnetic body contained in the paper sheet, as quantity of magnetism. For example, since a Hall element constantly changes linearly with respect to magnetic field intensity, it is possible to avoid the influence of individual differences of the respective component members and to highly accurately detect quantity of magnetism by using a Hall element as the magnetoelectric conversion element even if the individual differences are great.

Note that it is sufficient to dispose the magnetic field generation unit such that the magnetic field generation unit generates a magnetic field perpendicularly to the transport direction of a paper sheet, the magnetoelectric conversion element is provided between the transport path and the magnetic field generation unit, and the detection direction of the magnetoelectric conversion element is identical to the direction of the magnetic field. For example, in the configuration illustrated in Fig. 2, a magnetic field may be generated in a D3 direction and the magnetoelectric conversion element may detect in the D3 direction. However, a magnetic field may be generated in a D2 direction and the magnetoelectric conversion element may detect in the D2 direction.

The magnetic field generation unit generates magnetic field intensity of $10^3$ Oe or greater so that all the magnetic bodies contained in a paper sheet are brought into a saturated-magnetization state.

The correction unit can be given an arbitrary output current, for example, by using a DA converter. Note that in the present invention, it is sufficient that an arbitrary output current can be given. Therefore, for example, a voltage output from a DA converter which can set an arbitrary voltage may be converted to an arbitrary current by using a fixed resistor, or a constant voltage may be converted to an arbitrary current by using a variable resistor.

In addition, standard characteristic of the magnetic field generation unit and the magnetoelectric conversion element are determined. Output of the correction unit obtained when the output value of the magnetoelectric conversion element in the magnetic sensor device having the standard characteristics is set as the reference point of the bias magnetic field is specified as an ideal offset value. Output of a magnetic sensor device in which characteristics of the magnetic field generation unit or the magnetoelectric conversion element is different from the standard characteristics can be converted to standard output by using the specified ideal offset value and output of the correction unit set as the reference point of the bias magnetic field when a paper sheet is not transported.

Furthermore, in the present invention, a specific paper sheet is specified as a standard medium. An output value obtained when the standard medium is transported in the magnetic sensor device having the standard characteristics is specified as an ideal output reference value. Then, an output value obtained when the standard medium is transported in the magnetic sensor device is stored as a reference value in a nonvolatile memory. Output of a magnetic sensor device in which characteristics of the magnetic field generation unit or the magnetoelectric conversion element is different from the standard characteristics can be converted to standard output by using the specified ideal output reference value and the stored reference value.

The magnetic sensor device further includes: a feedback control unit which feeds back an output value from the amplification unit to input of the amplification unit so that the output value from the amplification unit becomes a reference point for representing the output value of the magnetoelectric conversion element by an offset; and a switching means which switches between the feedback control unit and the correction unit to be input to the amplification unit. A feedback time taken for the feedback control unit to bring the output value from the amplification unit back to the reference point is set to have delay time longer than the time taken for the entire paper sheet to pass through the magnetic sensor device.

The time during which output from the amplification unit changes due to a change in environment such as temperature is far longer than the time to transport a paper sheet. Therefore, if the feedback control unit takes a longer time to bring the output value from the amplification unit back to the reference point than the time during which a paper sheet is transported, it is possible to detect a change in the magnetic field which occurs when the paper sheet passes through, by subtracting the change in the magnetic field caused by the change in environment.

In addition, by connecting input of the amplification unit to input to the amplification unit by switching between the feedback control unit and the correction unit, it is possible to avoid not only the influence of individual differences of the respective component members such as the magnetic field generation unit and the magnetoelectric conversion element but also the influence of a change in environment and to highly accurately detect quantity of magnetism.

If a plurality of magnetoelectric conversion elements is disposed over the entire width of a paper sheet in a direction perpendicular to the transport direction of the paper sheet, a change in the magnetic field on the entire surface of the paper sheet caused when the paper sheet passes through can be detected as quantity of magnetism.

Furthermore, the storage unit has a capacity for storing the reference value of each magnetoelectric conversion element, and is configured to store the plurality of reference values. With this configuration, even if the magnetic field intensity and magnetic field detection sensitivity differ on the transport path due to variations in output difference according to individual differences of the magnetoelectric conversion elements and the magnetic field generation unit with respect to a magnetic sensor surface, each magnetoelectric conversion element can be converted to standard output.

According to the present invention, it is possible to appropriately eliminate individual differences of the magnetic field generation unit and the magnetoelectric conversion element and the individual differences with respect to the influence of a change in environment, to accurately extract from output of the magnetoelectric conversion element only the portion corresponding to a magnetic body in a paper sheet, and to stably detect all magnetic bodies contained in the paper sheet with high accuracy.

Furthermore, it is possible to appropriately correct a temporal change in the individual differences and to correct output of a magnetic sensor device to output of a magnetic sensor device defined as standard.

BRIEF DESCRIPTION OF THE DRAWINGS

Fig. 1 is a schematic cross-sectional view of a magnetic sensor device 1 according to a first embodiment of the present invention.
Fig. 2 is a cross-sectional view schematically illustrating a configuration of the magnetic sensor device 1 and a state of a magnetic field generated in the magnetic sensor device 1.
Fig. 3 is an explanatory diagram illustrating a signal processing circuit of a magnetoelectric conversion element 4 and a detection unit 7 according to the first embodiment.
Fig. 4A is an explanatory diagram explaining the principle of offset adjustment of a correction unit.

Fig. 4B is an explanatory diagram explaining the principle of offset adjustment of the correction unit.

Fig. 5 is a schematic view illustrating an example of a paper sheet S.

Fig. 6A is a diagram illustrating a magnetization curve of a magnetic body A.

Fig. 6B is a diagram illustrating a magnetization curve of a magnetic body B.

Fig. 6C is a diagram illustrating a magnetization curve of a magnetic body C.

Fig. 7 is an explanatory diagram illustrating a signal processing circuit of a magnetoelectric conversion element and a detection unit according to a second embodiment.

Fig. 8 is an explanatory diagram illustrating a signal processing circuit of a magnetoelectric conversion element and a detection unit according to a third embodiment.

Fig. 9 is an explanatory diagram illustrating a signal processing circuit of a magnetoelectric conversion element and a detection unit according to a fourth embodiment.

Fig. 10A is a diagram for explaining a mode of feedback control performed by a feedback control unit, and illustrates an example of the relationship between output and time before feedback control.

Fig. 10B is a diagram for explaining a mode of feedback control performed by the feedback control unit, and illustrates an example of the relationship between output and time in a case where a delay time is not provided for a feedback control unit.

Fig. 10C is a diagram for explaining a mode of feedback control performed by the feedback control unit, and illustrates an example of the relationship between output and time in a case where a delay time is provided for the feedback control unit.

Fig. 11 schematically illustrates a configuration of a magnetic sensor device according to the fourth embodiment from the top.

## MODE FOR CARRYING OUT THE INVENTION

Among the embodiments described in the following, the first, second and third embodiment represent example configurations for understanding basic concepts of the present invention. The fourth embodiment comprising, in particular, a feedback control unit is the embodiment according to the present invention.

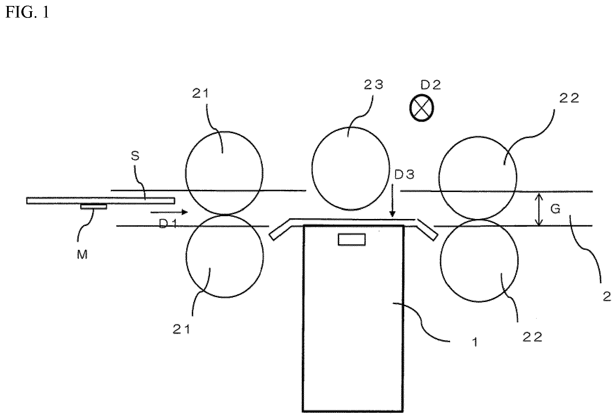

Fig. 1 is a schematic cross-sectional view of a magnetic sensor device 1 according to a first embodiment of the present invention. A magnetic pattern M is printed on a paper sheet S with magnetic ink, magnetic thread, or the like. The magnetic sensor device 1 detects quantity of magnetism of the magnetic pattern M included in the paper sheet S.

The transport path 2 is formed to have space G and a width slightly greater than the width of the paper sheet S along transport direction D1. The paper sheet S is fed into the transport path 2 by upstream transport rollers 21 and is further transported toward downstream transport rollers 22 by a sensor-facing roller 23 facing the magnetic sensor device 1. The sensor-facing roller 23 also has a function of pushing the paper sheet S in a direction D3 so that the paper sheet S approaches the magnetic sensor device 1. While the paper sheet S passes over the magnetic sensor device 1 as described above, a magnetic body of the paper sheet S is detected. Next, the paper sheet S is discharged from the transport path by the downstream transport rollers 22.

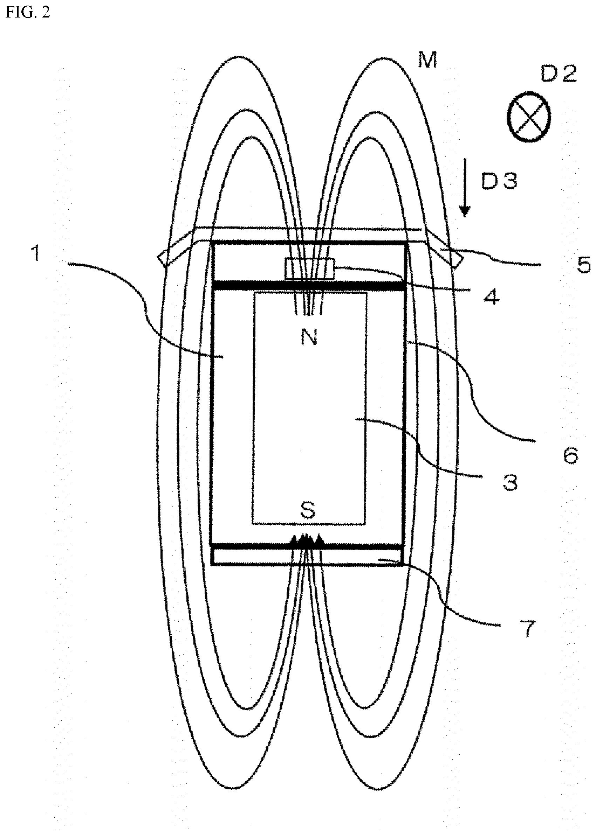

Fig. 2 is a cross-sectional view schematically illustrating a configuration of the magnetic sensor device 1 and a state of a magnetic field generated in the magnetic sensor device 1.

A magnetic field generation unit 3 is usually configured of a permanent magnet, and forms a bias magnetic field. Magnetic field intensity in the vicinity of the magnetoelectric conversion element 4 is set to $10^3$ Oe or greater. In this example, the magnetic field generation unit 3 is provided under the magnetoelectric conversion element 4 so that the N pole is located on the upper side and the S pole is located on the lower side. A loop-like magnetic flux as illustrated in Fig. 2 is formed around the magnetic field generation unit 3. In particular, in the vicinity of the magnetoelectric conversion element 4, a bias magnetic field vertical to the transport direction (see Fig. 1) of the paper sheet S is formed.

The magnetoelectric conversion element 4 is located in the bias magnetic field. Output of the magnetoelectric conversion element 4 is proportional to magnetic flux density of this bias magnetic field. When the paper sheet S passes over the magnetoelectric conversion element 4, the bias magnetic field changes due to the magnetic body contained in the paper sheet S. The magnetoelectric conversion element 4 detects the changed bias magnetic field.

The protection cover 5 is a cover for protecting the magnetoelectric conversion element 4 from the paper sheet S or the like, and is made of a non-magnetic body (for example, phosphor bronze). A case 6 is a housing that accommodates the magnetic field generation unit 3 and the magnetoelectric conversion element 4. The magnetic field generation unit 3 and the magnetoelectric conversion element 4 are fixed in a substantially sealed state such that the positional relationship between the magnetic field generation unit 3 and the magnetoelectric conversion element 4 does not change.

A detection unit 7 extracts from output of the magnetoelectric conversion element 4 only the portion corresponding to a change in the bias magnetic field caused by the magnetic body contained in the paper sheet S, and highly accurately detects the magnetic body of the paper sheet S.

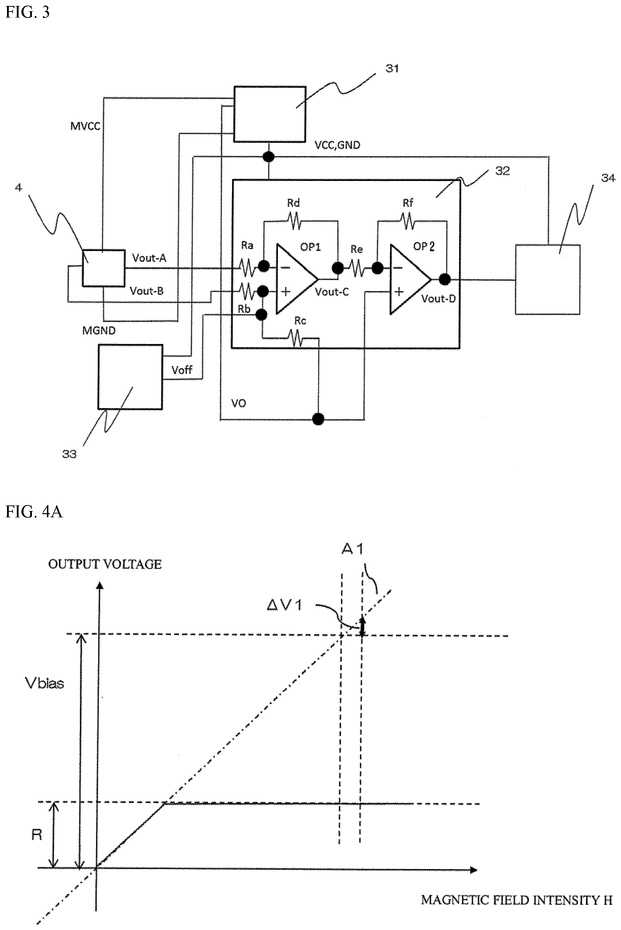

Fig. 3 illustrates a signal processing circuit of the magnetoelectric conversion element 4 and the detection unit 7 according to the first embodiment. The detection unit 7 includes a power supply unit 31, an amplification unit 32, a correction unit 33, and a determination unit 34.

The magnetoelectric conversion element 4 includes a MVCC voltage input terminal, a MGND ground terminal, and two voltage output terminals for Vout-A and Vout-B. A constant voltage is always maintained between the MVCC and the MGND connected to the power supply unit 31. The voltage difference between the two voltage output terminals Vout-A and Vout-B (hereinafter referred to as output of the magnetoelectric conversion element) is proportional to the magnetic flux density passing through the magnetoelectric conversion element 4. In the present embodiment, a constant voltage is set between the MVCC and the MGND; however, a constant current may be set between the MVCC and the MGND.

The power supply unit 31 further generates a constant voltage source VCC and a reference voltage source VO (to be described later) for driving the amplification unit 32, the correction unit 33, and the determination unit 34. The constant voltage source VCC and the reference voltage source VO have a ground GND in common.

The amplification unit 32 has two stages of operational amplifiers OP1 and OP2. Output voltages Vout-A and Vout-B from the magnetoelectric conversion element and an output voltage Voff from the correction unit 33 are connected to an input terminal of the operational amplifier OP1 in the preceding stage. More specifically, the output voltage Vout-A is connected to the operational amplifier OP1 via a resistor Ra, and the output voltage Vout-B is connected to a non-inverting input terminal via a resistor Rb. The non-inverting input terminal of the operational amplifier OP1 is connected to a reference voltage VO via the resistor Rc in addition to output from the correction unit 33. An output terminal Vout-C of the operational amplifier OP1 is connected to an inverting input terminal via a resistor Rd. Here, the resistance values of the resistors Ra and Rb are identical to each other, and the resistance values of the resistors Rc and Rd are identical to each other. The resistance value of each of the resistors Rc and Rd is set to predetermined times (for example, about 10 times) the resistance value of each of the resistors Ra and Rb.

On the input side of the operational amplifier OP2 on the subsequent end, output of the operational amplifier OP1 on the previous stage is connected to an inverting input terminal via a resistor Re, and the reference voltage VO is connected to a non-inverting input terminal, which is the other of the input terminals. An output terminal Vout-D of the operational amplifier OP2 is connected to the inverting input terminal via a resistor Rf. The resistance value of the resistor Rf is set to predetermined times (for example, about 100 times) the resistance value of the resistor Re.

The correction unit 33 is configured of, for example, a DA converter and can output an arbitrary current. Thus, it is possible to extract from output of the magnetoelectric conversion element 4 only the portion changed due to the magnetic body in the paper sheet S, by excluding the portion corresponding to the bias magnetic field. In other words, the correction unit 33 is configured to obtain as an offset the portion of the output of the magnetoelectric conversion element 4, the portion changed due to the magnetic body in the paper sheet S, by setting the portion of the output corresponding to the bias magnetic field as a reference point.

The determination unit 34 reads output Vout-D of the output operational amplifier OP2 of the amplification unit 32, detects the magnetic body in the paper sheet S transported on the transport path 2, and discriminates the paper sheet S.

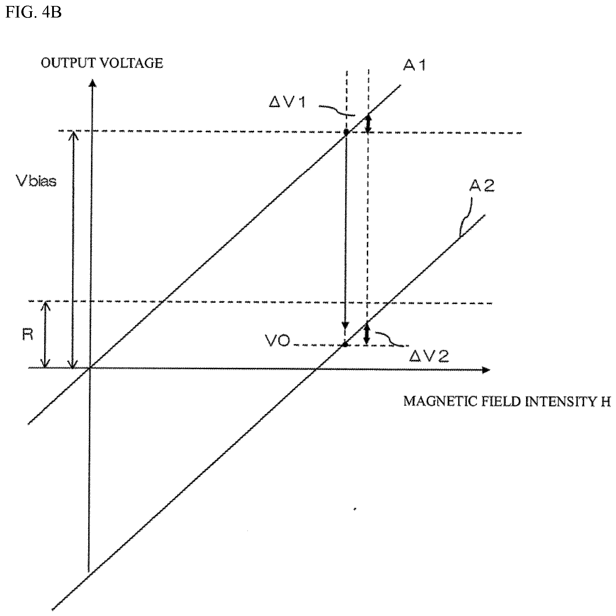

Figs. 4A and 4B are explanatory diagrams explaining the principle of offset adjustment performed by the correction unit 33 illustrated in Fig. 3.

The solid line portion of a straight line A1 in Fig. 4A illustrates the relationship of the output voltage (the output voltage Vout-D of the operational amplifier OP2) obtained by the amplification unit 32 amplifying output of the magnetoelectric conversion element 4 configured of a Hall element, when the bias magnetic field is changed. R is an actual output range of the amplification unit 32. The alternate long and short dash line portion of the straight line A1 indicates a virtual relationship between the bias magnetic field and the output voltage Vout-D when it is assumed that the output range of the amplification unit 32 is wider than the actual range. A virtual output voltage Vbias of the amplification unit 32 corresponding to the bias magnetic field actually generated by the magnetic field generation unit 3 is far greater than an output voltage $\Delta$V1 of the amplification unit 32 corresponding to a change in the bias magnetic field caused by the magnetic body in the paper sheet S. Therefore, the output voltage $\Delta$V1 cannot be discriminated from the saturation output of the amplification unit 32.

Therefore, as illustrated in Fig. 4B, in a state where the paper sheet S does not exist in the magnetic sensor device 1, the output voltage Voff adjusted by the correction unit 33 is subtracted from output of the magnetoelectric conversion element 4, and the output voltage Vbias is lowered to the reference voltage VO within the range R. Then, $\Delta$V2 corresponding to $\Delta$V1 can be detected by setting the output voltage of the amplification unit 32 obtained when the paper sheet S passes through to an offset value with reference to the reference voltage VO.

The determination unit 34 reads output of the amplification unit 32, detects the magnetic body in the paper sheet S transported on the transport path 2, and discriminates the paper sheet S.

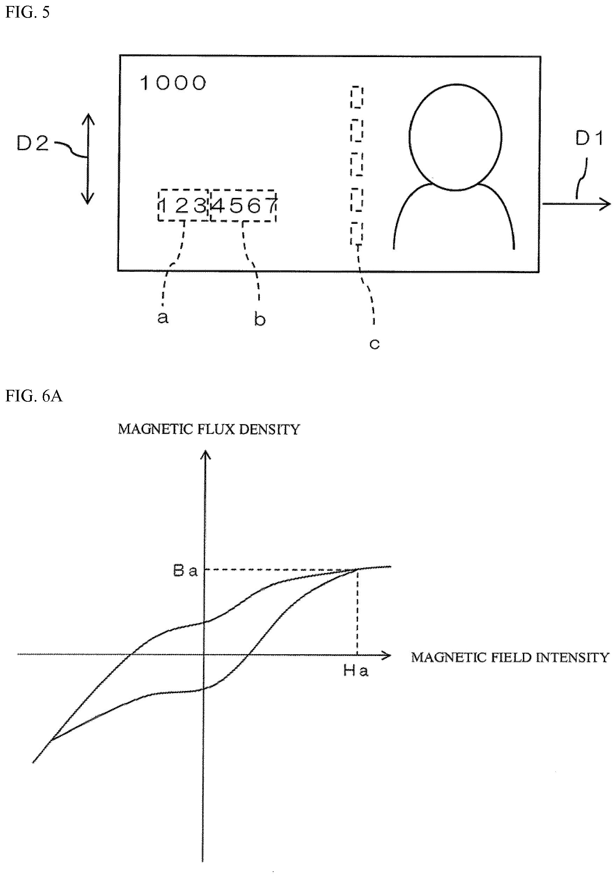

Fig. 5 is a schematic view illustrating an example of the paper sheet S. In this paper sheet S, for example, three types of magnetic bodies a, b, c having different saturation magnetic flux density are used. As will be described below, even when such a paper sheet S passes through the magnetic sensor device 1, it is possible to stably obtain output of the quantity of magnetism obtained by the magnetoelectric conversion element 4 sensing magnetic flux intensity of the magnetic bodies a, b, c.

In this example, some numbers are printed with magnetic ink containing the magnetic body a, and some other numbers are printed with magnetic ink containing the magnetic body b. In addition, printing with magnetic ink containing the magnetic body c is performed along a width direction D2. However, a magnetic body pattern M printed on the paper sheet S is not limited to the above-described pattern. In addition, the number of types of magnetic bodies a, b, and c to be used is not limited to three, and may be two or less, or four or more, for example.

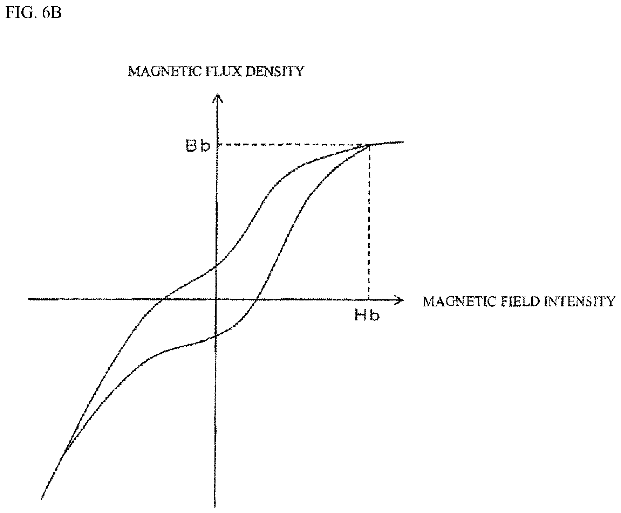

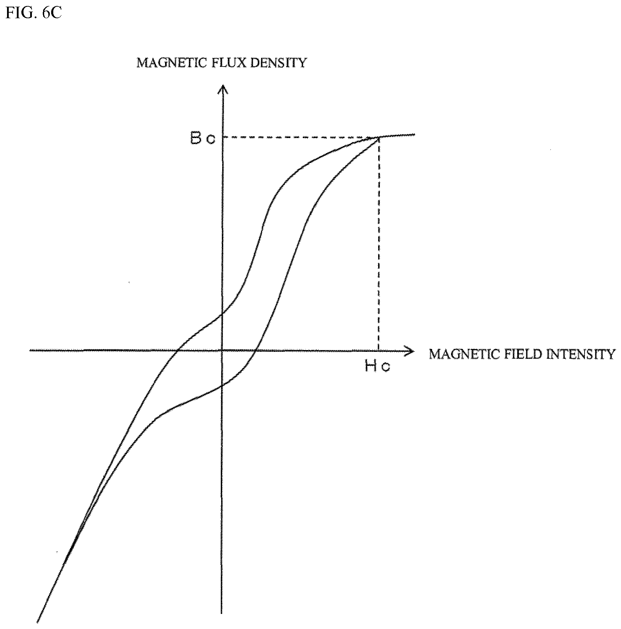

Figs. 6A, 6B and 6C illustrate B-H curves when the magnetic bodies a, b and c are placed in the magnetic field, respectively.

As illustrated in Fig. 6A, the magnetic flux density of the magnetic body a reaches saturation magnetic flux density Ba when the magnetic field intensity is Ha. Therefore, even when the magnetic field intensity becomes higher than Ha, the magnetic flux density hardly increases from Ba. The same applies to the magnetic body b and the magnetic body c (see Figs. 6B and 6C).

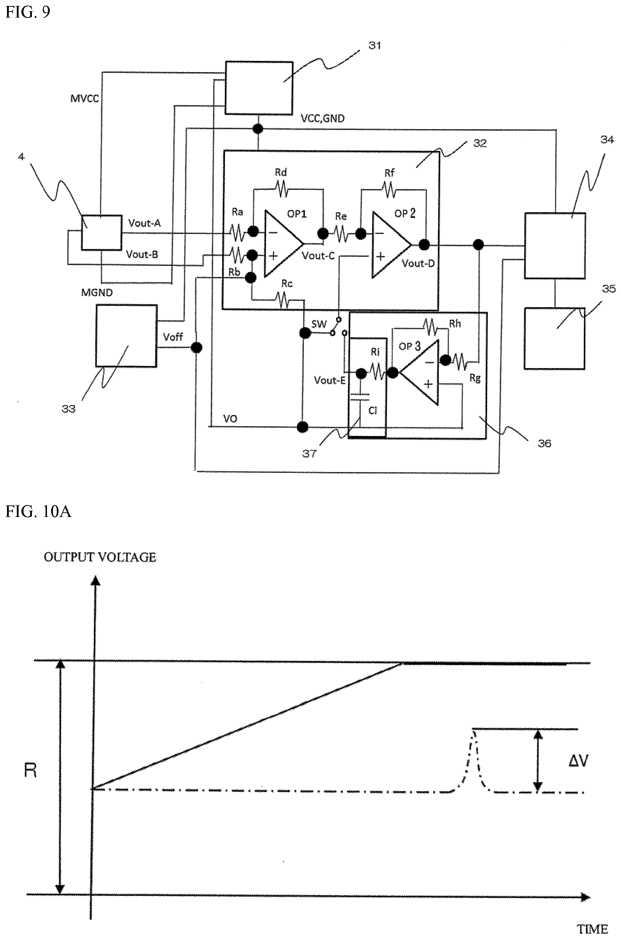

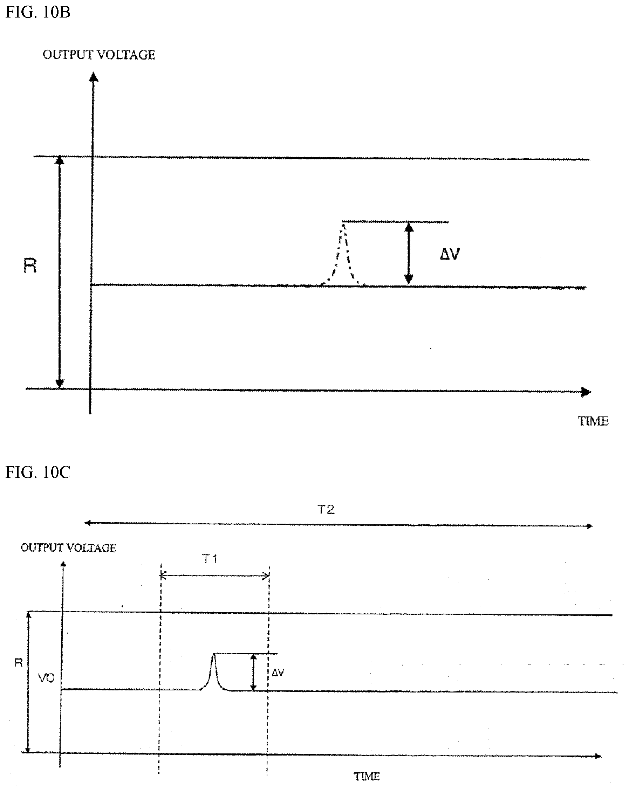

The magnetic bodies a, b, c are detected by the plurality of magnetoelectric conversion elements 4, respectively (see Figs. 10). All of the magnetoelectric conversion elements 4 are installed in a common bias magnetic field having magnetic field intensity H higher than any of Ha, Hb, and Hc. This magnetic field intensity H is $10^3$ Oe or greater with respect to most magnetic bodies.

In a case where the bias magnetic field is smaller than any one of or all of Ha, Hb, and Hc, the magnetic flux density of any one of or all of the magnetic bodies a, b, and c does not reach saturation, and is in an unstable state as illustrated in Figs. 6A, 6B, and 6C. In contrast, in a case where a bias magnetic field having the magnetic field intensity H is used as in the present embodiment, magnetic flux density of all the magnetic bodies reaches the saturation magnetic flux density, and output of quantity of magnetism sensed by the magnetoelectric conversion element 4 is stabilized.

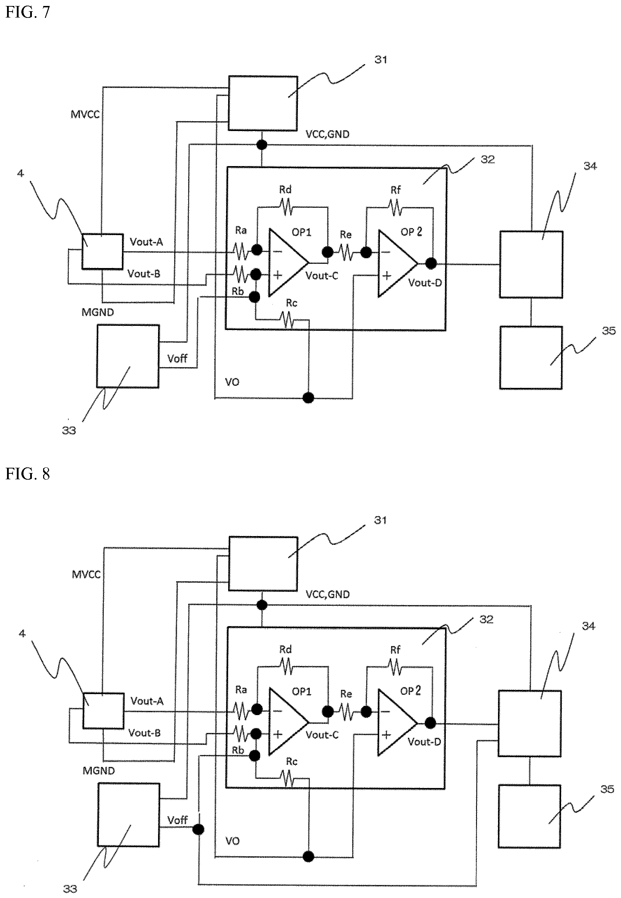

Fig. 7 illustrates a second embodiment of the present invention. In the circuit illustrated in Fig. 7, a storage unit 35 in which a nonvolatile storage medium is used is added to the determination unit 34 in Fig. 3 illustrating the first embodiment. Note that identical reference symbols are given to parts identical to those in the first embodiment. Generally, it is known that there are slight individual differences in proportionality coefficient of output of the magnetoelectric conversion element 4 to magnetic flux density, and there are individual differences in output of a magnetoelectric conversion element 4. In addition, there are individual differences in the performance of a magnetic field generation unit 3. According to the present embodiment, influences of the above individual differences are eliminated, and detection capability of a magnetic body is stably maintained.

First, a paper sheet defined as a standard product or a standard medium such as special magnetic printed matter which is used in lieu of the paper sheet and whose magnetic characteristics are uniform and stable is prepared (hereinafter, the paper sheet defined as the standard product is included in the standard medium). In a standard magnetic sensor device, intensity H1 of a bias magnetic field defined as standard is determined in advance, and a standard magnetoelectric conversion element whose output has a standard value, for example, an average value of output of the magnetoelectric conversion elements is used. Output of an amplification unit 32 obtained when the standard medium is transported to the standard magnetic sensor device is stored as standard output (reference value) in the storage unit 35 via a determination unit 34. In the storage unit 35, for example, a flash memory or the like is used as a recording medium.

Next, a second magnetic sensor device is prepared. The second magnetic sensor device includes a magnetic field generation unit 3 and a magnetoelectric conversion element 4 different from the standard magnetoelectric conversion element. In the second magnetic sensor device, output obtained when the above standard medium is transported is set as medium output (ideal output reference value).

Assuming that output obtained when a paper sheet S is transported to the second magnetic sensor device is paper sheet output, corrected paper sheet output calculated by the following formula is obtained when the identical paper sheet S is transported to the standard magnetic sensor device.

$$\text{Corrected paper sheet output} = \text{paper sheet output} \times (\text{standard output/medium output})$$

In other words, output of an arbitrary magnetic sensor device can be converted to output of the standard magnetic sensor device. By the method described above, the influence of individual differences of the magnetic field generation unit 3 and the magnetoelectric conversion element 4 are eliminated, and the magnetic body contained in the paper sheet S can be corrected to output of the standard magnetic sensor device.

In a case where a plurality of magnetoelectric conversion elements 4 are used, bias output is measured for each of the magnetoelectric conversion element 4 and corrected output of the paper sheet S expressed by the above formula is determined.

Fig. 8 illustrates a third embodiment of the present invention. In the circuit in Fig. 8, a determination unit 34 can read Voff output of the correction unit 33 in Fig. 7 illustrating the second embodiment. Note that identical reference symbols are given to parts identical to those in the second embodiment. Generally, it is known that there are slight individual differences in proportionality coefficient of output of the magnetoelectric conversion element 4 to magnetic flux density, and there are individual differences in output of a magnetoelectric conversion element 4. In addition, there are individual differences in the performance of a magnetic field generation unit 3. According to the present embodiment, influences of the above individual differences are eliminated, and detection capability of a magnetic body is stably maintained.

First, in a standard magnetic sensor device, intensity HI of a bias magnetic field defined as standard is known in advance, and a standard magnetoelectric conversion element whose output has a standard value, for example, an average value of output of the magnetoelectric conversion elements is used. Voff output of the correction unit 33 obtained when a portion of output of the magnetoelectric conversion element 4 of the standard magnetic sensor device, the portion corresponding to the intensity HI of the bias magnetic field is offset to a reference point is measured in advance as standard bias output.

Next, a second magnetic sensor device is prepared. The second magnetic sensor device includes a magnetic field generation unit 3 and a magnetoelectric conversion element 4 different from the standard magnetoelectric conversion element. Voff output of the correction unit 33 obtained when a portion of output of the magnetoelectric conversion element 4, the portion corresponding to intensity H2 of the bias magnetic field generated by the magnetic field generation unit 3 is offset to the reference point is set as bias output.

Assuming that output obtained when a paper sheet S is transported to the second magnetic sensor device is paper sheet output, corrected paper sheet output calculated by the following formula is obtained when the identical paper sheet S is transported to the standard magnetic sensor device.

$$\text{Corrected paper sheet output} = \text{paper sheet output} \times (\text{standard bias output/bias output})$$

In other words, output of an arbitrary magnetic sensor device can be converted to output of the standard magnetic sensor device.

By the method described above, the influence of individual differences of the magnetic field generation unit 3 and the magnetoelectric conversion element 4 are eliminated, and the magnetic body contained in the paper sheet S can be corrected to output of the standard magnetic sensor device.

In a case where a plurality of magnetoelectric conversion elements 4 are used, bias output is measured for each of the magnetoelectric conversion element 4 and corrected output of the paper sheet S expressed by the above formula is determined.

In Fig. 9 illustrating a fourth embodiment of the present invention, a feedback control unit 36 is added to the circuit in Fig. 8 illustrating the third embodiment. Fig. 10A illustrates an example of the relationship between an output signal Vout-D from the amplification unit 32 and time in the third embodiment. Generally, since the paper sheets S are always transported to the magnetic sensor device 1 except upon startup. Therefore, a state where there are no paper sheets S in the magnetic sensor device 1 is unknown. Therefore, there is no time for the correction unit 33 to eliminate from output of the magnetoelectric conversion element 4 the portion corresponding to the bias magnetic field.

For example, Fig. 10A illustrates an example of the relationship between an output signal Vout-D from the amplification unit 32 and time before feedback control. As indicated by an alternate long and short dash line in Fig. 10A, when there is no change in environment such as ambient temperature from the time of start-up, the output voltage Vout-D from the amplification unit 32 obtained when the paper sheet S is transported on the transport path 2 is almost constant even after time passes. A change appears in output $\Delta V$ only when a portion of the paper sheet where a magnetic body is contained passes over the magnetoelectric conversion element. However, in the magnetic sensor device 1, in a case where the output voltage Vout-D is saturated due to a change in environment, as indicated by for example, a solid line in Fig. 10A, output from the amplification unit 32 does not change when a portion of the paper sheet where a magnetic body is contained passes over the magnetoelectric conversion element. According to the present embodiment, influences of the above individual differences are eliminated, and detection capability of a magnetic body is stably maintained.

The feedback control unit 36 includes an operational amplifier OP3, resistors Rg, Rh, Ri, and a capacitor Ci. Output Vout-D from the amplification unit 32 is connected to an inverting input terminal of the operational amplifier OP3 via the resistor Rg. The reference voltage VO is connected to a non-inverting input terminal of the operational amplifier OP3. An output terminal of the operational amplifier OP3 is connected to the inverting input terminal of the operational amplifier OP3 via the resistor Rh. The resistance value of the resistor Rh is set to predetermined times (for example, about 1 time) the resistance value of the resistor Rg. Further, Vout-E is output to the output terminal of the operational amplifier OP3 via a delay circuit 37 formed of the resistor Ri and the capacitor Ci. The delay time of the delay circuit 37 is a constant set to time T which is much longer than the time taken for the entire paper sheet S to pass through the magnetic sensor device 1 on the transport path 2. That is, Vout-E is obtained by amplifying predetermined times of differential output between Vout-D and VO by the delay time T.

An SW (switching means) is a switch for performing switching between the output Vout-E from the feedback control unit 36 and the reference voltage VO. For example, the status of the magnetic sensor device 1 is divided into two statuses, that is, a start-up state and a normal state. In the start-up state, the SW is switched so as to be connected to the reference voltage VO, and therefore the reference voltage VO is connected to the non-inverting input terminal of the operational amplifier OP2 of the amplification unit 32. Then, in the normal state, the SW is switched so as to be connected to the output Vout-E of the feedback unit 36, and therefore the output Vout-E from the feedback control unit 36 is connected to the non-inverting input terminal of the operational amplifier OP2 of the amplification unit 32. That is, in the start-up state, the output terminal Vout-D of the operational amplifier OP2 is subjected to offset adjustment by changing the reference voltage VO by the correction unit 33. In the normal state, the output voltage Vout-D is always fixed at VO after the delay time T passes.

Fig. 10B is a diagram for explaining a mode of feedback control by the feedback control unit 36 which is performing discrimination. As indicated by the solid line in Fig. 10B, for example, even if the feedback unit 36 is provided, unless the delay time T is provided for the feedback unit 36, the output voltage Vout-D from the amplification unit 32 is fixed at VO and the output voltage Vout-D from the amplification unit 32 does not change even when the paper sheet S is transported.

Fig. 10C is a diagram for explaining a mode of feedback control by the feedback control unit 36 which is performing discrimination. Time T1 taken for the paper sheet S to pass through the magnetic sensor device 1 when the paper sheet S is transported on the transport path 2 is set as a reference. By setting delay time for the feedback unit 36, the delay time being predetermined time T2 much longer than the time T1 (for example, five times of the time T1 taken for the paper sheet S to pass through the magnetic sensor device 1), the output voltage Vout-D from the amplification unit 32 is fixed at VO in a time period equal to or longer than the predetermined time T2 in which a change over time occurs; however, the output signal Vout-D of the amplification unit 32 is not fixed at VO, and varied output from the magnetoelectric conversion element 4 can be detected within the time T1 in which the paper sheet S is transported.

Note that in the present embodiment, the status is divided into the start-up state and the normal state; however, the present invention is not limited to this. The status may be divided in any manner as long as a state where there are no paper sheets S in the magnetic sensor device 1 is known. For example, the state may be divided into a state where there are no paper sheets S and a state where the paper sheet S is being detected.

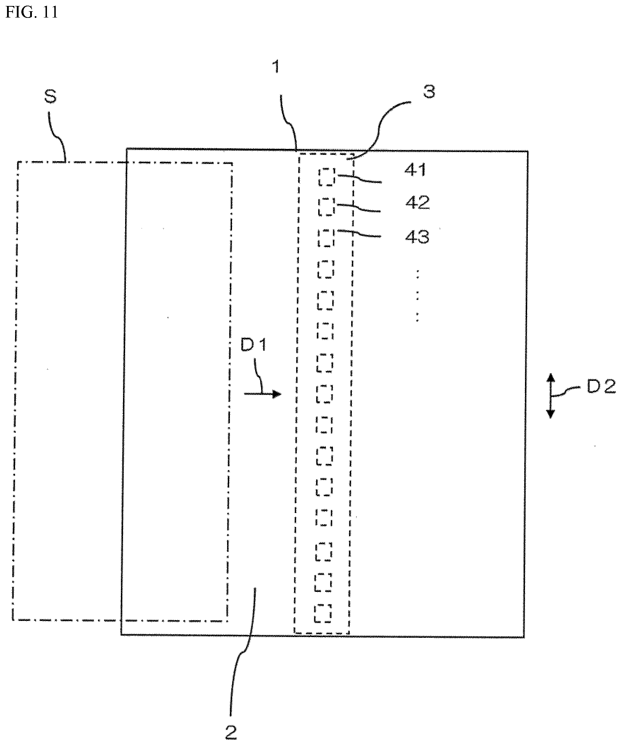

Fig. 11 schematically illustrates a configuration of a magnetic sensor device 1 according to a fifth embodiment from the top of a transport path 2. Note that identical reference symbols are given to parts identical to those in Fig. 2 illustrating the first embodiment.

In the fifth embodiment, a plurality of magnetoelectric conversion elements 41, 42, 43, ... is arranged in a direction perpendicular to a transport direction of a paper sheet S, and magnetic bodies distributed in the width direction of the paper sheet are simultaneously detected. A magnetic field intensity of $10^3$ Oe or greater is uniformly given to all the magnetoelectric conversion elements by a magnetic field generation unit 3 configured of a permanent magnet. The signal processing circuit illustrated in Fig. 3, Fig. 7, Fig. 8 or Fig. 9 is provided for each of the magnetoelectric conversion elements.

In Fig. 11, a plurality of Hall elements 41, 42, 43, ... are disposed in line in the long side direction of the magnetic field generation unit 3. However, the present invention is not limited to this. For example, Hall elements may be arranged in a zigzag manner in the long side direction of the magnetic field generation unit 3.

The rest of the configuration is identical to the configuration of the first embodiment, and the cross-sectional view in the direction D1 in Fig. 11 is similar to Fig. 2.

As described above, according to the present invention, as a basic unit of a magnetoelectric conversion element, a single magnetoelectric conversion element is used in lieu of a conventional set of magnetoelectric conversion elements. Therefore, it is possible to appropriately eliminate individual differences of the magnetic field generation unit and the magnetoelectric conversion element and the individual differences with respect to the influence of a change in environment, to accurately extract from output of the magnetoelectric conversion element only the portion corresponding to a magnetic body in a paper sheet, and to stably detect all the magnetic bodies contained in the paper sheet with high accuracy.

Furthermore, it is possible to appropriately correct a temporal change in the individual differences and to correct output of a magnetic sensor device to output of a magnetic sensor device defined as standard.

DESCRIPTION OF REFERENCE SIGNS

| 1 | Magnetic sensor device |
|---|---|
| 2 | Transport path |
| 21 | Upstream transport roller |
| 22 | Downstream transport roller |
| 23 | Sensor-facing roller |
| 3 | Magnetic field generation unit |
| 4, 41, 42, 43, ... | Magnetoelectric conversion element |
| 5 | Protection cover |
| 6 | Case |
| 7 | Detection unit |
| 31 | Power supply unit |
| 32 | Amplification unit |
| 33 | Correction unit |
| 34 | Determination unit |
| 35 | Storage unit |
| 36 | Feedback control unit |
| 37 | Delay circuit |

**Claims**

1. A magnetic sensor device (1) detecting a magnetic body (a, b, c) contained in a paper sheet (S) transported on a transport path (2), the device comprising:

   a magnetic field generation unit (3) which generates a bias magnetic field in an arbitrary direction on a plane perpendicular to a transport direction of the paper sheet on the transport path;
   a magnetoelectric conversion element (4; 41, 42, 43) which is provided in the bias magnetic field and between the transport path and the magnetic field generation unit and detects magnetic field intensity in a direction identical to a direction of the bias magnetic field;
   a correction unit (33) which sets a reference point for representing an output value of the magnetoelectric conversion element by an offset corresponding to the bias magnetic field generated by the magnetic field generation unit;
   an amplification unit (32) into which an output signal of the magnetoelectric conversion element and an output signal of the correction unit are input and which amplifies differential output of the output signal of the magnetoelectric conversion element and the output signal of the correction unit;
   a determination unit (34) which determines a characteristic of the magnetic body contained in the paper sheet, according to an output value from the amplification unit;
   a feedback control unit (36) which feeds back an output value from the amplification unit to input of the amplification unit so that an output value from the amplification unit becomes the reference point; and
   a switching means which switches between the feedback unit and the correction unit to be input to the amplification unit,
   wherein the output of the magnetoelectric conversion element changes linearly with respect to magnetic field intensity, and feedback time for the feedback control unit to make the output value from the amplification unit to become the reference point is longer than the delay time of the paper sheet to pass entirely through the magnetic sensor device.

2. The magnetic sensor device according to claim 1, wherein the magnetoelectric conversion element is a Hall element.

3. The magnetic sensor device according to claim 1 or 2, wherein the magnetic field generation unit generates magnetic field intensity of $10^3$ Oe or greater in the transport path on the magnetoelectric conversion element through which the paper sheet passes.

4. The magnetic sensor device according to any one of claims 1 to 3, wherein the correction unit gives arbitrary output by using a DA converter.

5. The magnetic sensor device according to any one of claims 1 to 4 further comprising a means which performs correction by using a ratio between output of the correction unit obtained when the output value of the magnetoelectric conversion element is set as a reference point of a predetermined bias magnetic field and output of the correction unit obtained when the paper sheet is not transported.

6. The magnetic sensor device according to any one of claims 1 to 4 further comprising:

> a storage unit which calculates a reference value from an output value of the magnetoelectric conversion element obtained when a known reference medium including a magnetic body is transported, and stores the reference value in advance; and
> a means which corrects an output value from the amplification unit obtained when a paper sheet is transported by a ratio between the reference value of the known reference medium stored in the storage unit and an ideal output reference value of the known reference medium.

7. The magnetic sensor device according to any one of claims 1 to 6, wherein a plurality of the magnetoelectric conversion elements is arranged side by side in a direction perpendicular to the transport direction of the paper sheet on the transport path.


**Patentansprüche**

1. Magnetsensorvorrichtung (1), die einen Magnetkörper (a, b, c) detektiert, der in einem Papierbogen (S) enthalten ist, der auf einem Förderweg (2) befördert wird, wobei die Vorrichtung Folgendes umfasst:

> eine Magnetfelderzeugungseinheit (3), die ein Vormagnetisierungsfeld in willkürlicher Richtung auf einer Ebene erzeugt, die normal auf eine Förderrichtung des Papierbogens auf dem Förderweg steht;
> ein magnetoelektrisches Wandlerelement (4; 41, 42, 43), das in dem Vormagnetisierungsfeld und zwischen dem Förderweg und der Magnetfelderzeugungseinheit bereitgestellt ist und eine Magnetfeldintensität in einer Richtung detektiert, die identisch zu einer Richtung des Vormagnetisierungsfelds ist;
> eine Korrektureinheit (33), die einen Referenzpunkt zur Darstellung eines Ausgangswerts des magnetoelektrischen Wandlerelements durch einen Offset, der dem von der Magnetfelderzeugungseinheit erzeugten Vormagnetisierungsfeld entspricht, festlegt;
> eine Verstärkungseinheit (32), in die ein Ausgangssignal des magnetoelektrischen Wandlerelements und ein Ausgangssignal der Korrektureinheit eingespeist wird und die das Differenzausgangssignal des Ausgangssignals der magnetoelektrischen Wandlereinheit und des Ausgangssignals der Korrektureinheit verstärkt;
> eine Bestimmungseinheit (34), die eine Charakteristik des Magnetkörpers, der in dem Papierbogen enthalten ist, gemäß einem Ausgangswert von der Verstärkungseinheit bestimmt;
> eine Rückkopplungssteuereinheit (36), die einen Ausgangswert von der Verstärkungseinheit zu dem Eingang der Verstärkungseinheit rückkoppelt, so dass ein Ausgangswert von der Verstärkungseinheit zum Referenzpunkt wird; und
> ein Schaltmittel, das zwischen der Rückkopplungseinheit und der Korrektureinheit umschaltet, um in die Verstärkungseinheit eingespeist zu werden,
> wobei sich das Ausgangssignal des magnetoelektrischen Wandlerelements in Bezug auf die Magnetfeldintensität linear ändert und die Rückkopplungszeit für die Rückkopplungssteuereinheit, um den Ausgangswert von der Verstärkungseinheit zu dem Referenzpunkt zu machen, länger ist als die Verzögerungszeit des Papierbogens, um die Magnetsensorvorrichtung vollständig zu durchlaufen.

2. Magnetsensorvorrichtung nach Anspruch 1, wobei das magnetoelektrische Wandlerelement ein Hall-Element ist.

3. Magnetsensorvorrichtung nach Anspruch 1 oder 2, wobei die Magnetfelderzeugungseinheit eine Magnetfeldintensität von $10^3$ Oe oder mehr auf dem Förderweg auf dem magnetoelektrischen Wandlerelement erzeugt, das der Papierbogen durchläuft.

4. Magnetsensorvorrichtung nach einem der Ansprüche 1 bis 3, wobei die Korrektureinheit unter Verwendung eines DA-Wandlers ein willkürliches Ausgangssignal liefert.

5. Magnetsensorvorrichtung nach einem der Ansprüche 1 bis 4, die außerdem ein Mittel umfasst, das unter Verwendung eines Verhältnisses zwischen dem Ausgangssignal der Korrektureinheit, das erhalten wird, wenn der Ausgangswert des magnetoelektrischen Wandlerelements als Referenzpunkt eines vorbestimmten Vormagnetisierungsfelds festgelegt wird, und dem Ausgangssignal der Korrektureinheit, das erhalten wird, wenn der Papierbogen nicht befördert wird, eine Korrektur durchführt.

**6.** Magnetsensorvorrichtung nach einem der Ansprüche 1 bis 4, die außerdem Folgendes umfasst:

eine Speichereinheit, die einen Referenzwert von einem Ausgangswert des magnetoelektrischen Wandlerelements berechnet, der erhalten wird, wenn ein bekanntes Referenzmedium, einschließlich eines Magnetkörpers, befördert wird, und den Referenzwert im Voraus speichert; und

ein Mittel, das einen Ausgangswert von der Verstärkungseinheit, der erhalten wird, wenn ein Papierbogen befördert wird, um ein Verhältnis zwischen dem Referenzwert des bekannten Referenzmediums, der in der Speichereinheit gespeichert ist, und einem idealen Ausgangsreferenzwert des bekannten Referenzmediums korrigiert.

**7.** Magnetsensorvorrichtung nach einem der Ansprüche 1 bis 6, wobei eine Vielzahl von magnetoelektrischen Wandlerelementen nebeneinander in einer Richtung, die normal auf die Förderrichtung des Papierbogens auf dem Förderweg steht, angeordnet ist.

**Revendications**

**1.** Dispositif de capteur magnétique (1) détectant un corps magnétique (a, b, c) contenu dans une feuille de papier (S) transportée sur un passage de transport (2), le dispositif comprenant:

une unité de génération de champ magnétique (3) qui génère un champ magnétique de polarisation dans une direction arbitraire sur un plan perpendiculaire à une direction de transport de la feuille de papier sur le passage de transport ;

un élément de conversion magnétoélectrique (4 ; 41, 42, 43) qui est disposé dans le champ magnétique de polarisation et entre le passage de transport et l'unité de génération de champ magnétique et qui détecte l'intensité du champ magnétique dans une direction identique à une direction du champ magnétique de polarisation ;

une unité de correction (33) qui fixe un point de référence pour représenter une valeur de sortie de l'élément de conversion magnétoélectrique par un décalage correspondant au champ magnétique de polarisation généré par l'unité de génération de champ magnétique ;

une unité d'amplification (32) dans laquelle sont entrés un signal de sortie de l'élément de conversion magnétoélectrique et un signal de sortie de l'unité de correction, et qui amplifie la sortie différentielle du signal de sortie de l'élément de conversion magnétoélectrique et du signal de sortie de l'unité de correction ;

une unité de détermination (34) qui détermine une caractéristique du corps magnétique contenu dans la feuille de papier selon une valeur de sortie en provenance de l'unité d'amplification ;

une unité d'asservissement (36) qui réinjecte une valeur de sortie en provenance de l'unité d'amplification dans l'entrée de l'unité d'amplification de telle sorte qu'une valeur de sortie en provenance de l'unité d'amplification devient le point de référence ; et

des moyens de commutation qui effectuent une commutation entre l'unité d'asservissement et l'unité de correction devant être entrée dans l'unité d'amplification,

dans lequel la sortie de l'élément de conversion magnétoélectrique varie de façon linéaire par rapport à l'intensité du flux magnétique, et le temps d'asservissement nécessaire pour que l'unité d'asservissement fasse que la valeur de sortie en provenance de l'unité d'amplification devienne le point de référence est plus long que le délai nécessaire pour que la feuille de papier traverse entièrement le dispositif de capteur magnétique.

**2.** Dispositif de capteur magnétique selon la revendication 1, dans lequel l'élément de conversion magnétoélectrique est un élément à effet Hall.

**3.** Dispositif de capteur magnétique selon la revendication 1 ou 2, dans lequel l'unité de génération de champ magnétique génère une intensité de champ magnétique de $10^3$ Oe ou plus dans le passage de transport sur l'élément de conversion magnétoélectrique traversé par la feuille de papier.

**4.** Dispositif de capteur magnétique selon l'une quelconque des revendications 1 à 3, dans lequel l'unité de correction fournit une sortie arbitraire à l'aide d'un convertisseur C/A.

**5.** Dispositif de capteur magnétique selon l'une quelconque des revendications 1 à 4, comprenant également des moyens qui effectuent une correction en utilisant un rapport entre la sortie de l'unité de correction obtenue quand la valeur de sortie de l'élément de conversion magnétoélectrique est fixée en tant que point de référence d'un champ magnétique de polarisation prédéterminé et une sortie de l'unité de correction obtenue quand la feuille de papier n'est pas transportée.

6. Dispositif de capteur magnétique selon l'une quelconque des revendications 1 à 4, comprenant également :

   une unité de mémoire qui calcule une valeur de référence à partir d'une valeur de sortie de l'élément de conversion magnétoélectrique obtenue quand un support de référence connu incluant un corps magnétique est transporté, et qui enregistre la valeur de référence à l'avance ; et
   un moyen qui corrige une valeur de sortie en provenance de l'unité d'amplification obtenue quand une feuille de papier est transportée selon un rapport entre la valeur de référence du support de référence connu enregistrée dans l'unité de mémoire et une valeur de référence de sortie idéale du support de référence connu.

7. Dispositif de capteur magnétique selon l'une quelconque des revendications 1 à 6, dans lequel une pluralité des éléments de conversion magnétoélectrique sont agencés côte à côte dans une direction perpendiculaire à la direction de transport de la feuille de papier sur le passage de transport.

FIG. 1

FIG. 2

FIG. 3

FIG. 4A

FIG. 4B

FIG. 5

FIG. 6A

FIG. 6B

MAGNETIC FLUX DENSITY

Bb

Hb

MAGNETIC FIELD INTENSITY

FIG. 6C

MAGNETIC FLUX DENSITY

B c

MAGNETIC FIELD INTENSITY

H c

FIG. 7

FIG. 8

FIG. 9

FIG. 10A

FIG. 10B

FIG. 10C

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014077276 A
- EP 2722983 A
- US 20080030191 A
- JP 52073793 A
- EP 2835660 A
- WO 2014168180 A
- JP 2000346605 A
- JP 2005037337 A
- JP 2003149313 A